# EUROPEAN PATENT APPLICATION

(11) **EP 4 488 336 A1**
(43) Date of publication of application: **08.01.2025**
(21) Application number: 23760085.3
(22) Date of filing: 24.02.2023
(51) Int. Cl.: C08L 101/00, B32B 15/082, B32B 27/30, C08J 5/24, C08L 9/00, C08L 35/00, C08L 53/02, H01L 23/29, H01L 23/31

(54) **RESIN COMPOSITION, PREPREG, LAMINATED BOARD, RESIN FILM, PRINTED WIRING BOARD, AND SEMICONDUCTOR PACKAGE**

(30) Priority: 28.02.2022 JP 2022030093
(71) Applicant: Resonac Corporation, Tokyo 105-7325 (JP)
(72) Inventor: SATO Naoyoshi, Tokyo 105-7325 (JP); TANIGAWA Takao, Tokyo 105-7325 (JP); FUKUI Masato, Tokyo 105-7325 (JP); AKEBI Ryuji, Tokyo 105-7325 (JP); TAKEGUCHI Ayaka, Tokyo 105-7325 (JP)
(74) Representative: Hoffmann Eitle
(86) International application number: PCT/JP2023/006630
(87) International publication number: WO 2023/163086

(57) **Abstract**

The present invention relates to a resin composition containing (A) a thermosetting resin and (B) a copolymer resin containing a structural unit derived from an aromatic vinyl compound and a structural unit derived from an unsaturated aliphatic hydrocarbon, in which the component (B) contains a component (B 1) having a content of a structural unit derived from an aromatic vinyl compound of 25 to 60% by mass, and a component (B2) having a content of a structural unit derived from an aromatic vinyl compound of less than that of the component (B 1) on a mass basis, and the content of the component (B 1) in the resin composition is greater than the content of the component (B2) in the resin composition on a mass basis; and a prepreg, a laminated board, a resin film, a printed wiring board, and a semiconductor package using the resin composition.

## Description

### Technical Field

The present embodiment relates to a resin composition, a prepreg, a laminated board, a resin film, a printed wiring board, and a semiconductor package.

### Background Art

In mobile communication devices represented by cellular phones, base stations thereof, network infrastructure devices such as servers and routers, and electronic devices such as large computers, the speed and volume of signals to be used have been increasing year by year. Accordingly, dielectric characteristics capable of reducing a transmission loss of a high-frequency signal (hereinafter, sometimes referred to as "high-frequency characteristics"), that is, a low relative dielectric constant and a low dielectric dissipation factor are required for a substrate material of a printed wiring board mounted on these electronic devices.

In recent years, in addition to the above-described electronic devices, practical use or practical planning of a new system handling a high-frequency radio signal is also being advanced in the Intelligent Transport Systems (ITS) field of an automobile, a traffic system, or the like and the short-distance communication field in the interior. Therefore, it is expected that the need for a substrate material having excellent high-frequency characteristics will increase also for a printed wiring board used in these fields in the future.

The printed wiring board is required to have heat resistance capable of withstanding the use environment. For this reason, a resin having excellent mechanical properties, such as a maleimide resin, has been used for the printed wiring board. However, since many of these resins excellent in mechanical properties contain a polar group, there is room for improvement in high-frequency characteristics.

Therefore, for example, a component that contributes to a low dielectric dissipation factor, such as a styrene-ethylene-butylene-styrene block copolymer (SEBS), has been used for a printed wiring board required to have a highly low transmission loss (for example, see PTL 1).

### Citation List

### Patent Literature

PTL 1: JP 2021-077786 A

### Summary of Invention

### Technical Problem

However, when the SEBS is used to achieve a low dielectric dissipation factor, there has been a problem that it is difficult to achieve both heat resistance and low dielectric dissipation factor.

In view of such a current situation, an object of the present embodiment is to provide a resin composition having both a low dielectric dissipation factor and heat resistance at a high level, and a prepreg, a laminated board, a resin film, a printed wiring board, and a semiconductor package using the resin composition.

### Solution to Problem

The present inventors have conducted studies to solve the above-described problems, and as a result, have found that the problems can be solved by the following embodiments [1] to [11].
[1] A resin composition containing (A) a thermosetting resin and (B) a copolymer resin containing a structural unit derived from an aromatic vinyl compound and a structural unit derived from an unsaturated aliphatic hydrocarbon,
   in which the component (B) contains
   a component (B1) having a content of a structural unit derived from an aromatic vinyl compound of 25 to 60% by mass, and
   a component (B2) having a content of a structural unit derived from an aromatic vinyl compound of less than that of the component (B1) on a mass basis, and
   the content of the component (B1) in the resin composition is greater than the content of the component (B2) in the resin composition on a mass basis.
[2] The resin composition according to [1], in which the structural unit derived from an aromatic vinyl compound contained in the component (B) is a structural unit derived from styrene.
[3] The resin composition according to [1] or [2], in which the structural unit derived from an unsaturated aliphatic hydrocarbon is a structural unit obtained by hydrogenating a structural unit formed by addition polymerization of a conjugated diene compound.
[4] The resin composition according to any one of [1] to [3], in which a ratio of the content of the component (B1) to the content of the component (B2) [(B1)/(B2)] is 1.1 to 10 in terms of a mass ratio.
[5] The resin composition according to any one of [1] to [4], in which the thermosetting resin (A) is one or more selected from the group consisting of a maleimide resin having one or more N-substituted maleimide groups and a derivative thereof.
[6] The resin composition according to any one of [1] to [5], further containing (C) one or more selected from the group consisting of a conjugated diene polymer and a modified conjugated diene polymer.
[7] A prepreg containing the resin composition according to any one of [1] to [6] or a semi-cured product of the resin composition.
[8] A laminated board including a cured product of the resin composition according to any one of [1] to [6], and a metal foil.
[9] A resin film containing the resin composition according to any one of [1] to [6] or a semi-cured product of the resin composition.
[10] A printed wiring board including a cured product of the resin composition according to any one of [1] to [6].
[11] A semiconductor package including the printed wiring board according to [10], and a semiconductor element.

### Advantageous Effects of Invention

According to the present embodiment, it is possible to provide a resin composition having both a low dielectric dissipation factor and heat resistance at a high level, and a prepreg, a laminated board, a resin film, a printed wiring board, and a semiconductor package using the resin composition.

### Description of Embodiments

In the description herein, a numerical range indicated by using "to" indicates a range including numerical values described before and after "to" as a minimum value and a maximum value, respectively.

For example, the expression of a numerical range "X to Y" (X and Y are real numbers) means a numerical range in which the range is equal to or greater than X and equal to or less than Y Further, the description of "X or more" in the description herein means X and a numerical value exceeding X. Furthermore, the description of "Y or less" in the description herein means Y and a numerical value less than Y

The lower limit value and the upper limit value of the numerical range described in the description herein can be arbitrarily combined with the lower limit value or the upper limit value of another numerical range, respectively.

In the numerical range described in the description herein, the lower limit value or the upper limit value of the numerical range may be replaced with a value shown in Examples.

Each component and material exemplified in the description herein may be used alone or may be used in combination of two or more kinds thereof, unless otherwise specified.

In the description herein, when a plurality of substances corresponding to each component are present in a resin composition, the content of each component in the resin composition means the total amount of the plurality of substances present in the resin composition, unless otherwise specified.

In the description herein, the term "solid content" means a component other than a solvent, and includes a liquid state, a starch syrup state, and a wax state at room temperature. In the description herein, room temperature means 25°C.

In the description herein, "(meth)acrylate" means "acrylate" and "methacrylate" corresponding thereto. Similarly, the term "(meth)acrylic" means "acrylic" and "methacrylic" corresponding thereto, and the term "(meth)acryloyl" means "acryloyl" and "methacryloyl" corresponding thereto.

The number-average molecular weight (Mn) in the description herein means a value measured by gel permeation chromatography (GPC) in terms of polystyrene. Specifically, the number-average molecular weight (Mn) in the description herein can be measured by a method described in Examples.

In the description herein, the "semi-cured product" has the same meaning as a resin composition in a B-stage state in JIS K 6800 (1985), and the "cured product" has the same meaning as a resin composition in a C-stage state in JIS K 6800 (1985).

The action mechanism described in the description herein is a conjecture, and does not limit the mechanism by which the effect of the present embodiment is exhibited.

An aspect in which the matters described in the description herein are arbitrarily combined is also included in the present embodiment.

### [Resin Composition]

The resin composition of the present embodiment is a resin composition containing (A) a thermosetting resin and (B) a copolymer resin containing a structural unit derived from an aromatic vinyl compound and a structural unit derived from an unsaturated aliphatic hydrocarbon,
in which the component (B) contains
a component (B1) having a content of a structural unit derived from an aromatic vinyl compound of 25 to 60% by mass, and
a component (B2) having a content of a structural unit derived from an aromatic vinyl compound of less than that of the component (B 1) on a mass basis, and
the content of the component (B 1) in the resin composition is greater than the content of the component (B2) in the resin composition on a mass basis.

In the description herein, each component may be abbreviated as component (A), component (B), or the like, and other components may be abbreviated in the same manner.

### <(A) Thermosetting Resin>

Examples of the thermosetting resin (A) include an epoxy resin, a phenol resin, a maleimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

The thermosetting resin (A) may be used alone or may be used in combination of two or more kinds thereof.

Among these, the thermosetting resin (A) is preferably one or more selected from the group consisting of an epoxy resin, a cyanate resin, and a maleimide resin, more preferably a maleimide resin, and still more preferably one or more selected from the group consisting of a maleimide resin having one or more N-substituted maleimide groups and a derivative of the maleimide resin, from the viewpoint of heat resistance and adhesiveness with a conductor.

In the following description, "one or more selected from the group consisting of a maleimide resin having one or more N-substituted maleimide groups and a derivative of the maleimide resin" may be referred to as "maleimide-based resin".

In addition, in the following description, a maleimide resin having one or more N-substituted maleimide groups may be referred to as a "maleimide resin (AX)" or a "component (AX)".

In addition, a derivative of a maleimide resin having one or more N-substituted maleimide groups may be referred to as a "maleimide resin derivative (AY)" or a "component (AY)".

### (Maleimide Resin (AX))

The maleimide resin (AX) is not particularly limited as long as it is a maleimide resin having one or more N-substituted maleimide groups.

The maleimide resin (AX) is preferably an aromatic maleimide resin having two or more N-substituted maleimide groups, and more preferably an aromatic bismaleimide resin having two N-substituted maleimide groups, from the viewpoint of adhesiveness with a conductor and heat resistance.

In the description herein, the "aromatic maleimide resin" means a compound having an N-substituted maleimide group directly bonded to an aromatic ring. Further, in the description herein, the "aromatic bismaleimide resin" means a compound having two N-substituted maleimide groups directly bonded to an aromatic ring. Furthermore, in the description herein, the "aromatic polymaleimide resin" means a compound having three or more N-substituted maleimide groups directly bonded to an aromatic ring. In addition, in the description herein, the "aliphatic maleimide resin" means a compound having an N-substituted maleimide group directly bonded to an aliphatic hydrocarbon.

As the maleimide resin (AX), a maleimide resin represented by the following general formula (A-1) is preferable. 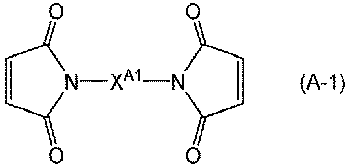 In the formula, X^{A1} is a divalent organic group.

X^{A1} in the general formula (A-1) is a divalent organic group.

Examples of the divalent organic group represented by X^{A1} in the general formula (A-1) include a divalent organic group represented by the following general formula (A-2), a divalent organic group represented by the following general formula (A-3), a divalent organic group represented by the following general formula (A-4), a divalent organic group represented by the following general formula (A-5), a divalent organic group represented by the following general formula (A-6), and a divalent organic group represented by the following general formula (A-7). 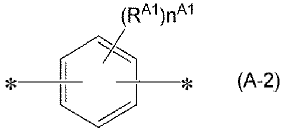 In the formula, R^{A1} is an aliphatic hydrocarbon group having 1 to 5 carbon atoms or a halogen atom; n^{A1} is an integer of 0 to 4; and * represents a bonding site.

Examples of the aliphatic hydrocarbon group having 1 to 5 carbon atoms represented by R^{A1} in the general formula (A-2) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group is still more preferable.

Examples of the halogen atom include a fluorine atom, a chlorine atom, a bromine atom, and an iodine atom.

In the general formula (A-2), n^{A1} is an integer of 0 to 4, and from the viewpoint of easy availability, preferably an integer of 0 to 2, more preferably 0 or 1, and still more preferably 0.

When n^{A1} is an integer of 2 or more, a plurality of R^{A1}'s may be the same as or different from each other. 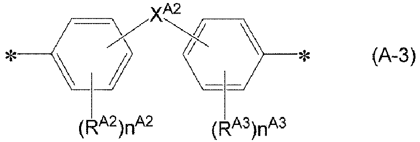 In the formula, R^{A2} and R^{A3} are each independently an aliphatic hydrocarbon group having 1 to 5 carbon atoms or a halogen atom; X^{A2} is an alkylene group having 1 to 5 carbon atoms, an alkylidene group having 2 to 5 carbon atoms, an ether group, a sulfide group, a sulfonyl group, a carbonyloxy group, a keto group, a single bond, or a divalent organic group represented by the following general formula (A-3-1); n^{A2} and n^{A3} are each independently an integer of 0 to 4; and * represents a bonding site.

Examples of the aliphatic hydrocarbon group having 1 to 5 carbon atoms represented by R^{A2} and R^{A3} in the general formula (A-3) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group and an ethyl group are still more preferable.

Examples of the halogen atom include a fluorine atom, a chlorine atom, a bromine atom, and an iodine atom.

Examples of the alkylene group having 1 to 5 carbon atoms represented by X^{A2} in the general formula (A-3) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and still more preferably a methylene group.

Examples of the alkylidene group having 2 to 5 carbon atoms represented by X^{A2} in the general formula (A-3) include an ethylidene group, a propylidene group, an isopropylidene group, a butylidene group, an isobutylidene group, a pentylidene group, and an isopentylidene group. Among these, an alkylidene group having 2 to 4 carbon atoms is preferable, an alkylidene group having 2 or 3 carbon atoms is more preferable, and an isopropylidene group is still more preferable.

n^{A2} and n^{A3} in the general formula (A-3) are each independently an integer of 0 to 4.

When n^{A2} or n^{A3} is an integer of 2 or more, a plurality of R^{A2}'s or a plurality of R^{A3}'s may be the same as or different from each other.

The divalent organic group represented by the general formula (A-3-1) represented by X^{A2} in the general formula (A-3) is as follows. 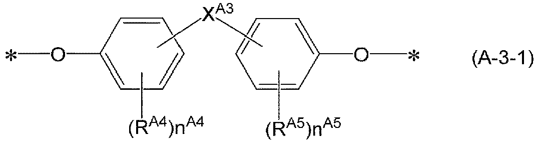 In the formula, R^{A4} and R^{A5} are each independently an aliphatic hydrocarbon group having 1 to 5 carbon atoms or a halogen atom; X^{A3} is an alkylene group having 1 to 5 carbon atoms, an alkylidene group having 2 to 5 carbon atoms, an ether group, a sulfide group, a sulfonyl group, a carbonyloxy group, a keto group, or a single bond; n^{A4} and n^{A5} are each independently an integer of 0 to 4; and * represents a bonding site.

Examples of the aliphatic hydrocarbon group having 1 to 5 carbon atoms represented by R^{A4} and R^{A5} in the general formula (A-3-1) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group is still more preferable.

Examples of the halogen atom include a fluorine atom, a chlorine atom, a bromine atom, and an iodine atom.

Examples of the alkylene group having 1 to 5 carbon atoms represented by X^{A3} in the general formula (A-3-1) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and still more preferably a methylene group.

Examples of the alkylidene group having 2 to 5 carbon atoms represented by X^{A3} in the general formula (A-3-1) include an ethylidene group, a propylidene group, an isopropylidene group, a butylidene group, an isobutylidene group, a pentylidene group, and an isopentylidene group. Among these, an alkylidene group having 2 to 4 carbon atoms is preferable, an alkylidene group having 2 or 3 carbon atoms is more preferable, and an isopropylidene group is still more preferable.

n^{A4} and n^{A5} in the general formula (A-3-1) are each independently an integer of 0 to 4, and from the viewpoint of easy availability, both of them are preferably an integer of 0 to 2, more preferably 0 or 1, and still more preferably 0.

When n^{A4} or n^{A5} is an integer of 2 or more, a plurality of R^{A4}'s or a plurality of R^{A5}'s may be the same as or different from each other.

As X^{A2} in the general formula (A-3), among the above-described options, an alkylene group having 1 to 5 carbon atoms, an alkylidene group having 2 to 5 carbon atoms, and a divalent organic group represented by the general formula (A-3-1) are preferable, an alkylene group having 1 to 5 carbon atoms is more preferable, and a methylene group is still more preferable. 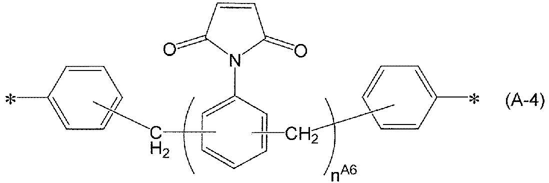 In the formula, n^{A6} is an integer of 0 to 10; and * represents a bonding site.

In the general formula (A-4), n^{A6} is preferably an integer of 0 to 5, more preferably an integer of 0 to 4, and still more preferably an integer of 0 to 3, from the viewpoint of easy availability. 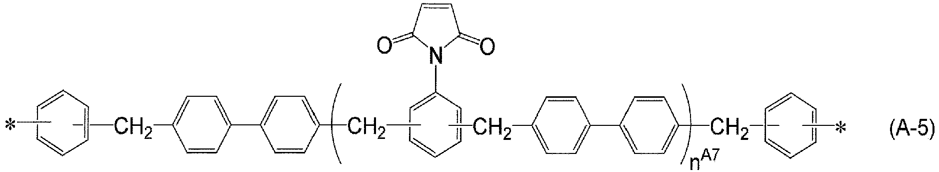 In the formula, n^{A7} is a number of 0 to 5; and * represents a bonding site.

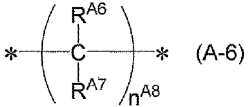

In the formula, R^{A6} and R^{A7} are each independently a hydrogen atom or an aliphatic hydrocarbon group having 1 to 5 carbon atoms; n^{A8} is an integer of 1 to 8; and * represents a bonding site.

Examples of the aliphatic hydrocarbon group having 1 to 5 carbon atoms represented by R^{A6} and R^{A7} in the general formula (A-6) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched.

In the general formula (A-6), n^{A8} is an integer of 1 to 8, preferably an integer of 1 to 5, more preferably an integer of 1 to 3, and still more preferably 1. When n^{A8} is an integer of 2 or more, a plurality of R^{A6}'s or a plurality of R^{A7}'s may be the same as or different from each other. 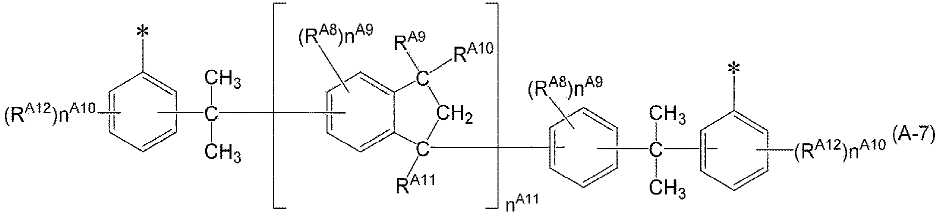 In the formula, R^{A8} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, and n^{A9} is an integer of 0 to 3; R^{A9} to R^{A11} are each independently an alkyl group having 1 to 10 carbon atoms; R^{A12} is each independently an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group; n^{A10} is each independently an integer of 0 to 4, and n^{A11} is a numerical value of 0.95 to 10.0; and * represents a bonding site.

Examples of the alkyl group having 1 to 10 carbon atoms represented by R^{A8} in the general formula (A-7) include a methyl group, an ethyl group, a propyl group, a butyl group, a pentyl group, a hexyl group, a heptyl group, an octyl group, and a decyl group. These alkyl groups may be either linear or branched.

Examples of the alkyl groups contained in the alkyloxy group having 1 to 10 carbon atoms and the alkylthio group having 1 to 10 carbon atoms represented by R^{A8} include the same as alkyl groups having 1 to 10 carbon atoms described above.

Examples of the aryl group having 6 to 10 carbon atoms represented by R^{A8} include a phenyl group and a naphthyl group.

Examples of the aryl groups contained in the aryloxy group having 6 to 10 carbon atoms and the arylthio group having 6 to 10 carbon atoms represented by R^{A8} include the same as aryl groups having 6 to 10 carbon atoms described above.

Examples of the cycloalkyl group having 3 to 10 carbon atoms represented by R^{A8} include a cyclopropyl group, a cyclobutyl group, a cyclopentyl group, a cyclohexyl group, a cycloheptyl group, a cyclooctyl group, and a cyclodecyl group.

In a case where n^{A9} in the general formula (A-7) is an integer of 1 to 3, from the viewpoint of solvent solubility and reactivity, R^{A8} is preferably an alkyl group having 1 to 4 carbon atoms, a cycloalkyl group having 3 to 6 carbon atoms, or an aryl group having 6 to 10 carbon atoms, and more preferably an alkyl group having 1 to 4 carbon atoms.

Examples of the alkyl group having 1 to 10 carbon atoms represented by R^{A9} to R^{A11} include a methyl group, an ethyl group, a propyl group, a butyl group, a pentyl group, a hexyl group, a heptyl group, an octyl group, and a decyl group. These alkyl groups may be either linear or branched. Among these, R^{A9} to R^{A11} are preferably an alkyl group having 1 to 4 carbon atoms, more preferably a methyl group or an ethyl group, and still more preferably a methyl group.

In the general formula (A-7), n^{A9} is an integer of 0 to 3, and when n^{A9} is 2 or 3, a plurality of R^{A8}'s may be the same as or different from each other.

Among these, the divalent organic group represented by the general formula (A-7) is preferably a divalent organic group in which n^{A9} is 0 and R^{A9} to R^{A11} are each a methyl group, from the viewpoint of compatibility with other resins, solvent solubility, dielectric characteristics, adhesiveness with a conductor, and ease of production.

In the general formula (A-7), a plurality of R^{A8}'s, a plurality of R^{A12}'s, a plurality of n^{A9}'s, and a plurality of n^{A10}'s may be the same as or different from each other. In addition, in a case where n^{A11} is greater than 1, a plurality of R^{A9}'s, a plurality of R^{A10}'s, and a plurality of R^{A11}'s may be the same as or different from each other.

The description of the alkyl group having 1 to 10 carbon atoms, the alkyloxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{A12} in the general formula (A-7) is the same as the description of the alkyl group having 1 to 10 carbon atoms, the alkyloxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{A8}.

Among these, from the viewpoint of compatibility with other resins, solvent solubility, dielectric characteristics, adhesiveness with a conductor, and ease of production, R^{A12} is preferably an alkyl group having 1 to 4 carbon atoms, a cycloalkyl group having 3 to 6 carbon atoms, and an aryl group having 6 to 10 carbon atoms, and more preferably an alkyl group having 1 to 3 carbon atoms.

In the general formula (A-7), n^{A10} is an integer of 0 to 4, and from the viewpoint of compatibility with other resins, solvent solubility, dielectric characteristics, adhesiveness with a conductor, and ease of production, n^{A10} is preferably an integer of 0 to 3, and more preferably 0 or 2.

When n^{A10} is 1 or more, the benzene ring and the N-substituted maleimide group have a twisted conformation, and the intermolecular stacking is suppressed, and thus the solvent solubility tends to be further improved. From the same viewpoint, when n^{A10} is 1 or more, the substitution position of R^{A12} is preferably an ortho-position with respect to the N-substituted maleimide group.

From the viewpoint of compatibility with other resins, solvent solubility, melt viscosity, handleability, and heat resistance, n^{A11} in the general formula (A-7) is preferably 0.98 to 8.0, more preferably 1.0 to 7.0, and still more preferably 1.1 to 6.0.

Preferred examples of the divalent organic group represented by the general formula (A-7) include a divalent organic group represented by the following general formula (A-7-1), a divalent organic group represented by the following general formula (A-7-2), a divalent organic group represented by the following general formula (A-7-3), and a divalent organic group represented by the following general formula (A-7-4).

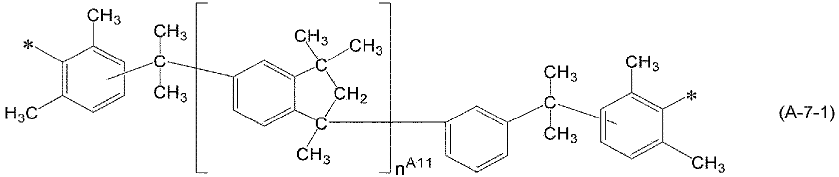

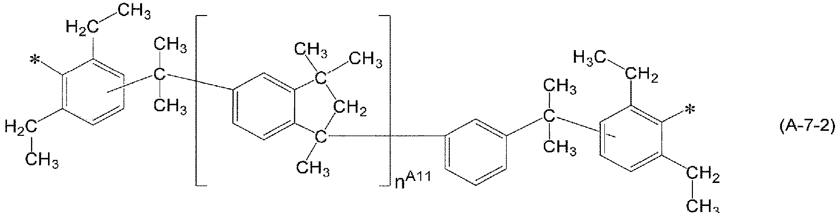

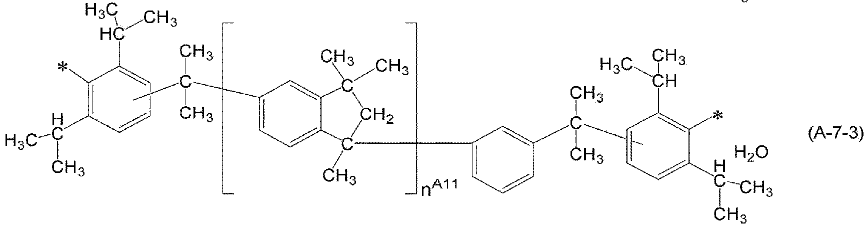

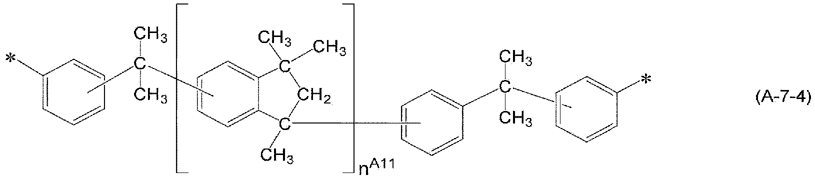

In the formulae, n^{A11} is the same as defined above in the general formula (A-7); and * represents a bonding site.

Examples of the maleimide resin (AX) include aromatic bismaleimide resins, aromatic polymaleimide resins, and aliphatic maleimide resins, and among these, aromatic bismaleimide resins are preferred.

Specific examples of the maleimide resin (AX) include N,N'-ethylenebismaleimide, N,N'-hexamethylenebismaleimide, N,N'-(1,3-phenylene)bismaleimide, N,N'-[1,3-(2-methylphenylene)]bismaleimide, N,N'-[1,3-(4-methylphenylene)]bismaleimide, N,N'-(1,4-phenylene)bismaleimide, bis(4-maleimidophenyl)methane, bis(3-methyl-4-maleimidophenyl)methane, 3,3'-dimethyl-5,5'-diethyl-4,4'-diphenylmethanebismaleimide, bis(4-maleimidophenyl)ether, bis(4-maleimidophenyl)sulfone, bis(4-maleimidophenyl)sulfide, bis(4-maleimidophenyl)ketone, bis(4-maleimidocyclohexyl)methane, 1,4-bis(4-maleimidophenyl)cyclohexane, 1,4-bis(maleimidomethyl)cyclohexane, 1,4-bis(maleimidomethyl)benzene, 1,3-bis(4-maleimidophenoxy)benzene, 1,3-bis(3-maleimidophenoxy)benzene, bis[4-(3-maleimidophenoxy)phenyl]methane, bis[4-(4-maleimidophenoxy)phenyl]methane, 1,1-bis[4-(3-maleimidophenoxy)phenyl]ethane, 1,1-bis[4-(4-maleimidophenoxy)phenyl]ethane, 1,2-bis[4-(3-maleimidophenoxy)phenyl]ethane, 1,2-bis[4-(4-maleimidophenoxy)phenyl]ethane, 2,2-bis[4-(3-maleimidophenoxy)phenyl]propane, 2,2-bis[4-(4-maleimidophenoxy)phenyl]propane, 2,2-bis[4-(3-maleimidophenoxy)phenyl]butane, 2,2-bis[4-(4-maleimidophenoxy)phenyl]butane, 2,2-bis[4-(3-maleimidophenoxy)phenyl]-1,1,1,3,3,3-hexafluoropropane, 2,2-bis[4-(4-maleimidophenoxy)phenyl]-1,1,1,3,3,3-hexafluoropropane, 4,4-bis(3-maleimidophenoxy)biphenyl, 4,4-bis(4-maleimidophenoxy)biphenyl, bis[4-(3-maleimidophenoxy)phenyl]ketone, bis[4-(4-maleimidophenoxy)phenyl]ketone, bis(4-maleimidophenyl)disulfide, bis[4-(3-maleimidophenoxy)phenyl]sulfide, bis[4-(4-maleimidophenoxy)phenyl]sulfide, bis[4-(3-maleimidophenoxy)phenyl]sulfoxide, bis[4-(4-maleimidophenoxy)phenyl]sulfoxide, bis[4-(3-maleimidophenoxy)phenyl]sulfone, bis[4-(4-maleimidophenoxy)phenyl]sulfone, bis[4-(3-maleimidophenoxy)phenyl]ether, bis[4-(4-maleimidophenoxy)phenyl]ether, 1,4-bis[4-(4-maleimidophenoxy)-α,α-dimethylbenzyl]benzene, 1,3-bis[4-(4-maleimidophenoxy)-α,α-dimethylbenzyl]benzene, 1,4-bis[4-(3-maleimidophenoxy)-α,α-dimethylbenzyl]benzene, 1,3-bis[4-(3-maleimidophenoxy)-α,α-dimethylbenzyl]benzene, 1,4-bis[4-(4-maleimidophenoxy)-3,5-dimethyl-α,α-dimethylbenzyl]benzene, 1,3-bis[4-(4-maleimidophenoxy)-3,5-dimethyl-α,α-dimethylbenzyl]benzene, 1,4-bis[4-(3-maleimidophenoxy)-3,5-dimethyl-α,α-dimethylbenzyl]benzene, 1,3-bis[4-(3-maleimidophenoxy)-3,5-dimethyl-α,α-dimethylbenzyl]benzene, polyphenylmethane maleimide, an aromatic bismaleimide resin having an indan skeleton, and a biphenyl aralkyl type maleimide resin. Among these, an aromatic bismaleimide resin having an indane skeleton, a biphenyl aralkyl type maleimide resin, and 3,3'-dimethyl-5,5'-diethyl-4,4'-diphenylmethane bismaleimide are preferable, and it is more preferable to use one or more selected from the group consisting of an aromatic bismaleimide resin having an indane skeleton and a biphenyl aralkyl type maleimide resin in combination with 3,3'-dimethyl-5,5'-diethyl-4,4'-diphenylmethane bismaleimide.

### (Maleimide Resin Derivative (AY))

As the maleimide resin derivative (AY), an aminomaleimide resin containing a structural unit derived from the above-described maleimide resin (AX) and a structural unit derived from a diamine compound is preferable.

Examples of the structural unit derived from the maleimide resin (AX) contained in the aminomaleimide resin include a structural unit in which at least one N-substituted maleimide group in the N-substituted maleimide group of the maleimide resin (AX) is subjected to a Michael addition reaction with an amino group of the diamine compound.

The structural unit derived from the maleimide resin (AX) contained in the aminomaleimide resin may be one type alone, or may be two or more types thereof.

Examples of the structural unit derived from a diamine compound contained in the aminomaleimide resin include a structural unit in which one or both of the amino groups of two amino groups of a diamine compound are subjected to a Michael addition reaction with an N-substituted maleimide group of the maleimide resin (AX).

The structural unit derived from the diamine compound contained in the aminomaleimide resin may be one type alone, or may be two or more types thereof.

Examples of the diamine compound include aromatic diamine compounds such as 4,4'-diaminodiphenylmethane, 3,3'-dimethyl-4,4'-diaminodiphenylmethane, 3,3'-diethyl-4,4'-diaminodiphenylmethane, 4,4'-diaminodiphenylether, 4,4'-diaminodiphenylsulfone, 3,3'-diaminodiphenylsulfone, 4,4'-diaminodiphenylketone, 4,4'-diaminobiphenyl, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3'-dimethyl-5,5'-diethyl-4,4'-diaminodiphenylmethane, 2,2-bis(4-aminophenyl)propane, 2,2-bis[4-(4-aminophenoxy)phenyl]propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 1,3-bis[1-[4-(4-aminophenoxy)phenyl]-1-methylethyl]benzene, 1,4-bis[1-[4-(4-aminophenoxy)phenyl]-1-methylethyl]benzene, 4,4'-[1,3-phenylenebis(1-methylethylidene)]bisaniline, 4,4'-[1,4-phenylenebis(1-methylethylidene)]bisaniline, 3,3'-[1,3-phenylenebis(1-methylethylidene)]bisaniline, bis[4-(4-aminophenoxy)phenyl]sulfone, bis[4-(3-aminophenoxy)phenyl]sulfone, and 9,9-bis(4-aminophenyl)fluorene; and silicone compounds having two primary amino groups.

In the description herein, the "aromatic diamine compound" means a compound having two amino groups directly bonded to an aromatic ring.

### (Content of (A) Thermosetting Resin)

The content of the thermosetting resin (A) in the resin composition of the present embodiment is not particularly limited, and is preferably 5 to 90% by mass, more preferably 10 to 60% by mass, and still more preferably 20 to 40% by mass with respect to the total amount (100% by mass) of the resin components in the resin composition of the present embodiment.

When the content of the thermosetting resin (A) is equal to or greater than the lower limit value, the heat resistance, moldability, processability, and adhesiveness with a conductor tend to be more easily improved. On the other hand, when the content of the thermosetting resin (A) is equal to or less than the upper limit value, the dielectric characteristics tend to be more easily improved.

Here, in the description herein, the "resin component" means a resin and a compound which forms a resin by a curing reaction.

For example, in the resin composition of the present embodiment, the component (A) and the component (B) correspond to resin components.

In a case where the resin composition of the present embodiment contains, as an optional component, a resin or a compound that forms a resin by a curing reaction in addition to the above-described components, these optional components are also included in the resin component. Examples of the optional component corresponding to the resin component include a component (C) which will be described later.

On the other hand, a component (D), a component (E), and a component (F) are not included in the resin component.

The total content of the resin components in the resin composition of the present embodiment is not particularly limited, and is preferably 20 to 70% by mass, more preferably 25 to 60% by mass, and still more preferably 30 to 50% by mass with respect to the total solid content (100% by mass) of the resin composition of the present embodiment from the viewpoint of low thermal expansion properties, heat resistance, flame retardancy, and adhesiveness with a conductor.

### <(B) Copolymer Resin Containing Structural Unit Derived from Aromatic Vinyl Compound and Structural Unit Derived from Unsaturated Aliphatic Hydrocarbon>

The resin composition of the present embodiment can reduce the dielectric dissipation factor by containing the component (B).

In addition, the resin composition of the present embodiment contains, as a component (B), a component (B 1) in which a structural unit derived from an aromatic vinyl compound is 25 to 60% by mass and a component (B2) in which a content of a structural unit derived from an aromatic vinyl compound is less than that of the component (B 1) on a mass basis, and has a configuration in which the content of the component (B 1) in the resin composition is greater than the content of the component (B2) in the resin composition on a mass basis, thereby achieving a high level of both low dielectric dissipation factor and heat resistance.

It is considered that the structural unit derived from the aromatic vinyl compound contained in the component (B) contributes to improvement of heat resistance by the intermolecular interaction thereof. Therefore, normally, when the component (B2) having a relatively low content of the structural unit derived from the aromatic vinyl compound is blended, heat resistance is expected to be lowered. However, according to the resin composition of the present embodiment, although the detailed cause is unknown, by setting the content of the structural unit derived from the aromatic vinyl compound in the component (B 1) and the relative blending amount of the component (B 1) and the component (B2) within the above ranges, it is possible to reduce the dielectric dissipation factor while maintaining good heat resistance.

Each of the component (B 1) and the component (B2) may be used alone or may be used in combination of two or more kinds thereof. In addition, the component (B) may contain one or more copolymer resins containing a structural unit derived from an aromatic vinyl compound and a structural unit derived from an unsaturated aliphatic hydrocarbon other than the component (B 1) and the component (B2).

As the structural unit derived from the aromatic vinyl compound contained in the component (B), a structural unit represented by the following general formula (B-1) is preferable. 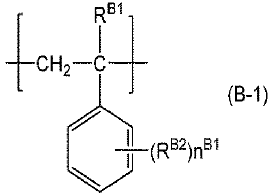 In the formula, R^{B1} is a hydrogen atom or an alkyl group having 1 to 5 carbon atoms, R^{B2} is an alkyl group having 1 to 5 carbon atoms, and n^{B1} is an integer of 0 to 5.

Examples of the alkyl group having 1 to 5 carbon atoms represented by R^{B1} and R^{B2} in the general formula (B-1) include a methyl group, an ethyl group, a n-propyl group, an isopropyl group, a n-butyl group, an isobutyl group, a t-butyl group, and a n-pentyl group. The alkyl group having 1 to 5 carbon atoms may be either linear or branched. Among these, an alkyl group having 1 to 3 carbon atoms is preferable, an alkyl group having 1 or 2 carbon atoms is more preferable, and a methyl group is still more preferable. In the general formula (B-1), n^{B1} is an integer of 0 to 5, preferably an integer of 0 to 2, more preferably an integer of 0 or 1, and still more preferably 0.

Among the structural units represented by the above, the structural unit derived from an aromatic vinyl compound contained in the component (B) is preferably a structural unit derived from styrene.

The structural unit derived from an unsaturated aliphatic hydrocarbon contained in the component (B) is preferably a structural unit derived from a conjugated diene compound.

Examples of the conjugated diene compound include 1,3-butadiene, isoprene, 1,3-pentadiene, 2,3-dimethyl-1,3-butadiene, 2-phenyl-1,3-butadiene, and 1,3-hexadiene. The structural unit derived from the conjugated diene compound may be one type alone, or may be two or more types thereof.

Among these, as the conjugated diene compound, 1,3-butadiene and isoprene are preferable, and 1,3-butadiene is more preferable.

The structural unit derived from an unsaturated aliphatic hydrocarbon is preferably a structural unit obtained by hydrogenating a structural unit formed by addition polymerization of a conjugated diene compound. In the case of being hydrogenated, the structural unit derived from 1,3-butadiene becomes a structural unit in which an ethylene unit and a butylene unit are mixed, and the structural unit derived from isoprene becomes a structural unit in which an ethylene unit and a propylene unit are mixed.

Examples of the component (B) include a hydrogenated product of a styrene-butadiene-styrene block copolymer and a hydrogenated product of a styrene-isoprene-styrene block copolymer.

Examples of the hydrogenated product of the styrene-butadiene-styrene block copolymer include a styrene-ethylene-butylene-styrene block copolymer (SEBS) obtained by completely hydrogenating a carbon-carbon double bond in a butadiene block, and a styrene-butadiene-butylene-styrene block copolymer (SBBS) obtained by partially hydrogenating a carbon-carbon double bond in a 1,2-bonding site in a butadiene block. The complete hydrogenation in SEBS means that the hydrogenation rate of the entire carbon-carbon double bonds is usually 90% or more, may be 95% or more, may be 99% or more, and may be 100%. In addition, the partial hydrogenation rate in SBBS is, for example, 60 to 85% with respect to the entire carbon-carbon double bonds. A hydrogenated product of a styrene-isoprene-styrene block copolymer is obtained as a styrene-ethylene-propylene-styrene block copolymer (SEPS) in which a polyisoprene block is hydrogenated.

Among these, SEBS and SEPS are preferable, and SEBS is more preferable, from the viewpoint of dielectric characteristics, adhesiveness with a conductor, heat resistance, glass transition temperature, and low thermal expansion properties.

The content of the structural unit derived from the aromatic vinyl compound in the component (B 1) is 25 to 60% by mass. As a result, the resin composition of the present embodiment has excellent heat resistance.

The content of the structural unit derived from the aromatic vinyl compound in the component (B 1) is preferably 26 to 50% by mass, more preferably 27 to 40% by mass, and still more preferably 28 to 35% by mass from the viewpoint of further improving the balance between low dielectric dissipation factor and heat resistance.

The total content of the structural unit derived from an aromatic vinyl compound and the structural unit derived from an unsaturated aliphatic hydrocarbon in the component (B 1) is not particularly limited, and is preferably 80 to 100% by mass, more preferably 90 to 100% by mass, and still more preferably 95 to 100% by mass, from the viewpoint of further improving the balance between low dielectric dissipation factor and heat resistance.

The content of the structural unit derived from an aromatic vinyl compound in the component (B2) is preferably 10 to 50% by mass, more preferably 15 to 30% by mass, and still more preferably 18 to 22% by mass, from the viewpoint of further improving the balance between dielectric dissipation factor and heat resistance, within a range smaller than the content of the structural unit derived from an aromatic vinyl compound in the component (B 1).

The difference between the content (1) of the structural unit derived from an aromatic vinyl compound in the component (B 1) and the content (2) of the structural unit derived from an aromatic vinyl compound in the component (B2) [(1) - (2)] is not particularly limited, and is preferably 5 to 25% by mass, more preferably 7 to 20% by mass, and still more preferably 9 to 15% by mass from the viewpoint of further improving the balance between low dielectric dissipation factor and heat resistance.

The total content of the structural unit derived from an aromatic vinyl compound and the structural unit derived from an unsaturated aliphatic hydrocarbon in the (B2) component is not particularly limited, and is preferably 80 to 100% by mass, more preferably 90 to 100% by mass, and still more preferably 95 to 100% by mass, from the viewpoint of further improving the balance between low dielectric dissipation factor and heat resistance.

### (Content of Component (B))

The content of the component (B) in the resin composition of the present embodiment is not particularly limited, and is preferably 1 to 60% by mass, more preferably 20 to 50% by mass, and still more preferably 30 to 45% by mass with respect to the total amount (100% by mass) of the resin components in the resin composition of the present embodiment.

When the content of the component (B) is equal to or greater than the lower limit value, the dielectric characteristics tend to be more easily improved. On the other hand, when the content of the component (B) is equal to or less than the upper limit value, the heat resistance tends to be more easily improved.

The content of the component (B 1) in the resin composition of the present embodiment is larger than the content of the component (B2) in the resin composition of the present embodiment on a mass basis.

The content of the component (B 1) in the resin composition of the present embodiment is not particularly limited, and from the viewpoint of further improving the balance between low dielectric dissipation factor and heat resistance, the content is preferably 2 to 50% by mass, more preferably 15 to 40% by mass, and still more preferably 20 to 35% by mass with respect to the total amount (100% by mass) of the resin components in the resin composition of the present embodiment.

The content of the component (B2) in the resin composition of the present embodiment is not particularly limited, and from the viewpoint of further improving the balance between low dielectric dissipation factor and heat resistance, the content is preferably 1 to 30% by mass, more preferably 5 to 20% by mass, and still more preferably 10 to 15% by mass with respect to the total amount (100% by mass) of the resin components in the resin composition of the present embodiment.

The ratio of the content of the component (B1) to the content of the component (B2) in the resin composition of the present embodiment [(B1)/(B2)] is not particularly limited, and from the viewpoint of further improving the balance between low dielectric dissipation factor and heat resistance, the ratio is preferably 1.1 to 10, more preferably 1.5 to 7, and still more preferably 2 to 3 in terms of a mass ratio.

The total content of the component (B1) and the component (B2) with respect to the total amount (100% by mass) of the component (B) is not particularly limited, and is preferably 80 to 100% by mass, more preferably 90 to 100% by mass, and still more preferably 95 to 100% by mass from the viewpoint of further improving the balance between low dielectric dissipation factor and heat resistance.

### <(C) One or More Selected from the Group Consisting of Conjugated Diene Polymer and Modified Conjugated Diene Polymer>

From the viewpoint of dielectric characteristics, the resin composition of the present embodiment preferably further contains (C) one or more selected from the group consisting of a conjugated diene polymer and a modified conjugated diene polymer.

The definition of the component (C) does not include the component (B).

The component (C) may be used alone or may be used in combination of two or more kinds thereof.

### (Conjugated Diene Polymer)

In the description herein, the "conjugated diene polymer" means a polymer of a conjugated diene compound.

By containing the conjugated diene polymer, the resin composition of the present embodiment tends to easily obtain more excellent dielectric characteristics.

Examples of the conjugated diene compound which is a monomer component of the conjugated diene polymer include 1,3-butadiene, isoprene, 1,3-pentadiene, 2,3-dimethyl-1,3-butadiene, 2-phenyl-1,3-butadiene, and 1,3-hexadiene.

The conjugated diene polymer may be a polymer of one kind of conjugated diene compound or a copolymer of two or more kinds of conjugated diene compounds.

In addition, the conjugated diene polymer may be a copolymer of one or more kinds of conjugated diene compounds and one or more kinds of monomers other than the conjugated diene compound.

When the conjugated diene polymer is a copolymer, the polymerization mode is not particularly limited, and may be any of random polymerization, block polymerization, and graft polymerization.

As the conjugated diene polymer, a conjugated diene polymer having a vinyl group in a side chain is preferable from the viewpoint of compatibility with other resins and dielectric characteristics.

The number of the side chain vinyl groups contained in one molecule of the conjugated diene polymer is not particularly limited, and is preferably 2 or more, more preferably 5 or more, and still more preferably 10 or more from the viewpoint of compatibility with other resins and dielectric characteristics.

The upper limit of the number of the side chain vinyl groups contained in one molecule of the conjugated diene polymer is not particularly limited, and for example, may be 100 or less, may be 80 or less, or may be 60 or less.

Examples of the conjugated diene polymer include polybutadiene having a vinyl group and polyisoprene having a vinyl group. Among these, from the viewpoint of dielectric characteristics and heat resistance, polybutadiene having a vinyl group is preferable, and polybutadiene having a 1,2-vinyl group derived from 1,3-butadiene is more preferable. In addition, as the polybutadiene having a 1,2-vinyl group derived from 1,3-butadiene, a polybutadiene homopolymer having a 1,2-vinyl group derived from 1,3-butadiene is preferable.

The 1,2-vinyl group derived from 1,3-butadiene contained in the conjugated diene polymer is a vinyl group contained in the structural unit represented by the following formula (C-1).

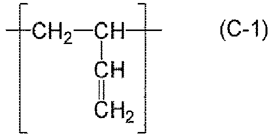

When the conjugated diene polymer is polybutadiene having a 1,2-vinyl group, the content of the structural unit having a 1,2-vinyl group (hereinafter, sometimes referred to as "vinyl group content") based on the total structural units derived from butadiene constituting the polybutadiene is not particularly limited, and is preferably 50 mol% or more, more preferably 70 mol % or more, and still more preferably 85 mol % or more, from the viewpoint of compatibility with other resins, dielectric characteristics, and heat resistance. The upper limit of the vinyl group content is not particularly limited, and may be 100 mol% or less, may be 95 mol% or less, or may be 90 mol% or less. The structural unit having a 1,2-vinyl group is preferably a structural unit represented by the above formula (C-1).

From the same viewpoint, the polybutadiene having a 1,2-vinyl group is preferably a 1,2-polybutadiene homopolymer.

The number-average molecular weight (Mn) of the conjugated diene polymer is not particularly limited, and is preferably 400 to 3,000, more preferably 600 to 2,000, and still more preferably 800 to 1,500, from the viewpoint of compatibility with other resins, dielectric characteristics, and heat resistance.

### (Modified Conjugated Diene Polymer)

The modified conjugated diene polymer is a polymer obtained by modifying a conjugated diene polymer.

The resin composition of the present embodiment tends to have more excellent dielectric characteristics while having good heat resistance and low thermal expansion properties by containing the modified conjugated diene polymer.

As the modified conjugated diene polymer, a modified conjugated diene polymer obtained by modifying a conjugated diene polymer having a vinyl group in a side chain with a maleimide resin having two or more N-substituted maleimide groups is preferable from the viewpoint of compatibility with other resins, dielectric characteristics, and adhesiveness with a conductor.

As the conjugated diene polymer having a vinyl group in a side chain, for example, the conjugated diene polymer having a vinyl group in a side chain described as the conjugated diene polymer can be used, and preferred embodiments are also the same.

The conjugated diene polymer having a vinyl group in a side chain may be used alone or may be used in combination of two or more kinds thereof.

As the maleimide resin having two or more N-substituted maleimide groups, for example, the maleimide resin having two or more N-substituted maleimide groups described as the maleimide resin (AX) can be used, and preferred embodiments are also the same.

The maleimide resin having two or more N-substituted maleimide groups may be used alone or may be used in combination of two or more kinds thereof.

The modified conjugated diene polymer preferably has, in a side chain, a substituent formed by a reaction between a side chain vinyl group of a conjugated diene polymer having a vinyl group in a side chain and an N-substituted maleimide group of a maleimide resin having two or more N-substituted maleimide groups [hereinafter, sometimes referred to as a "maleimide resin-derived substituent"].

The maleimide resin-derived substituent is preferably a group containing a structure represented by the following general formula (C-2) or (C-3) as a structure derived from a maleimide resin having two or more N-substituted maleimide groups, from the viewpoint of compatibility with other resins, dielectric characteristics, low thermal expansion properties, and heat resistance. 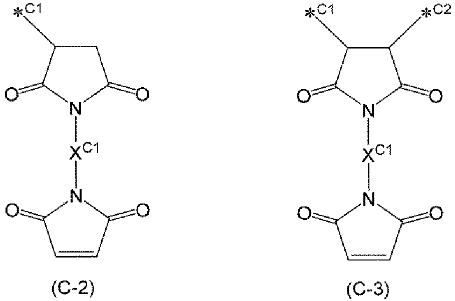 In the formula, X^{C1} is a divalent group obtained by removing two N-substituted maleimide groups from a maleimide resin having two or more N-substituted maleimide groups, *^{C1} is a site bonded to a carbon atom derived from a side chain vinyl group of a conjugated diene polymer having a vinyl group in a side chain, and *^{C2} is a site bonded to another atom.

The modified conjugated diene polymer preferably has a maleimide resin-derived substituent and a vinyl group in a side chain.

The vinyl group contained in the modified conjugated diene polymer is preferably a 1,2-vinyl group derived from 1,3-butadiene.

The number-average molecular weight (Mn) of the modified conjugated diene polymer is not particularly limited, and is preferably 700 to 6,000, more preferably 800 to 5,000, and still more preferably 1,000 to 2,500, from the viewpoint of compatibility with other resins, dielectric characteristics, low thermal expansion properties, and heat resistance.

The modified conjugated diene polymer can be produced by reacting a conjugated diene polymer having a vinyl group in the side chain with a maleimide resin having two or more N-substituted maleimide groups.

The method for reacting the conjugated diene polymer having a vinyl group in the side chain with the maleimide resin having two or more N-substituted maleimide groups is not particularly limited. For example, the modified conjugated diene polymer can be obtained by charging a conjugated diene polymer having a vinyl group in a side chain, a maleimide resin having two or more N-substituted maleimide groups, a reaction catalyst, and an organic solvent into a reaction vessel, and allowing them to react while heating, keeping warm, or stirring is performed as necessary.

The ratio (Mₘ/Mᵥ) of the number of moles (Mₘ) of the N-substituted maleimide group in the maleimide resin having two or more N-substituted maleimide groups to the number of moles (Mᵥ) of the side chain vinyl group in the conjugated diene polymer having a vinyl group in a side chain during the reaction is not particularly limited, and is preferably 0.001 to 0.5, more preferably 0.005 to 0.1, and still more preferably 0.008 to 0.05 from the viewpoint of compatibility with other resins of the resulting modified conjugated diene polymer and suppression of gelation of the product during the reaction.

### (Content of Component (C))

When the resin composition of the present embodiment contains the component (C), the content of the component (C) is not particularly limited, and is preferably 5 to 50% by mass, more preferably 10 to 40% by mass, and still more preferably 20 to 35% by mass, with respect to the total amount (100% by mass) of the resin components in the resin composition of the present embodiment.

When the content of the component (C) is equal to or greater than the lower limit value, the dielectric characteristics tend to be more easily improved. On the other hand, when the content of the component (C) is equal to or less than the upper limit value, the heat resistance and flame retardancy tend to be more easily improved.

### <(D) Inorganic Filler>

The resin composition of the present embodiment preferably further contains (D) an inorganic filler from the viewpoint of low thermal expansion properties, elastic modulus, heat resistance, and flame retardancy.

The inorganic filler (D) may be used alone or may be used in combination of two or more kinds thereof.

Examples of the inorganic filler (D) include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide. Among these, from the viewpoint of low thermal expansion properties, elastic modulus, heat resistance, and flame retardancy, silica, alumina, mica, and talc are preferable, silica and alumina are more preferable, and silica is still more preferable.

Examples of silica include precipitated silica produced by a wet method and having a high water content, and dry process silica produced by a dry process and containing almost no bound water. Further, examples of dry process silica include crushed silica, fumed silica, and fused silica, for example, depending on the difference in the production method.

The average particle diameter of the inorganic filler (D) is not particularly limited, and is preferably 0.01 to 20 µm, more preferably 0.1 to 10 µm, and still more preferably 0.2 to 1 µm. Here, the average particle diameter of the inorganic filler (D) is a particle diameter at a point corresponding to 50% by volume when a cumulative frequency distribution curve based on the particle diameter is obtained with the total volume of the particles as 100%. The particle size of the inorganic filler (D) can be measured by a particle size distribution measuring apparatus using a laser diffraction scattering method.

Examples of the shape of the inorganic filler (D) include a spherical shape and a crushed shape, and a spherical shape is preferable.

When the resin composition of the present embodiment contains the inorganic filler (D), a coupling agent may be used for the purpose of improving dispersibility of the inorganic filler (D) and adhesiveness to the organic component. Examples of the coupling agent include a silane coupling agent and a titanate coupling agent.

### (Content of Inorganic Filler (D))

When the resin composition of the present embodiment contains the inorganic filler (D), the content of the inorganic filler (D) is not particularly limited, and from the viewpoint of low thermal expansion properties, elastic modulus, heat resistance and flame retardancy, the content is preferably 10 to 90% by mass, more preferably 20 to 80% by mass, still more preferably 30 to 70% by mass, and particularly preferably 40 to 60% by mass, with respect to the total solid content (100% by mass) of the resin composition of the present embodiment.

### <(E) Curing Accelerator>

From the viewpoint of improving curability, the resin composition of the present embodiment preferably further contains (E) a curing accelerator.

The curing accelerator (E) may be used alone or may be used in combination of two or more kinds thereof.

Examples of the curing accelerator (E) include acidic catalysts such as p-toluenesulfonic acid; amine compounds such as triethylamine, pyridine, and tributylamine; imidazole compounds such as methylimidazole and phenylimidazole; isocyanate-masked imidazole compounds such as an addition reaction product of hexamethylene diisocyanate resin and 2-ethyl-4-methylimidazole; tertiary amine compounds; quaternary ammonium compounds; phosphorus-based compounds such as triphenylphosphine; organic peroxides such as dicumyl peroxide, 2,5-dimethyl-2,5-bis(t-butylperoxy)hexyne-3,2,5-dimethyl-2,5-bis(t-butylperoxy)hexane, t-butylperoxyisopropyl monocarbonate, and α,α'-bis(t-butylperoxy)diisopropylbenzene; and carboxylates of manganese, cobalt, and zinc.

Among these, from the viewpoint of heat resistance, glass transition temperature, and storage stability, organic peroxides are preferable, and dicumyl peroxide is more preferable.

### (Content of Curing Accelerator (E))

When the resin composition of the present embodiment contains the curing accelerator (E), the content of the curing accelerator (E) is not particularly limited, and is preferably 0.01 to 10 parts by mass, more preferably 0.1 to 5 parts by mass, and still more preferably 0.5 to 2 parts by mass, with respect to 100 parts by mass of the total amount of the resin components in the resin composition of the present embodiment.

When the content of the curing accelerator (E) is equal to or greater than the lower limit value, heat resistance, adhesiveness with a conductor, elastic modulus, and glass transition temperature tend to be more favorable. On the other hand, when the content of the curing accelerator (E) is equal to or less than the upper limit value, dielectric characteristics and storage stability tend to be more favorable.

### <(F) Flame Retardant>

When the resin composition of the present embodiment contains (F) a flame retardant, the flame retardancy of the resin composition tends to be further improved.

The flame retardant (F) may be used alone or may be used in combination of two or more kinds thereof. Further, a flame retardant aid may be contained as required.

Examples of the flame retardant (F) include a phosphorus-based flame retardant, a metal hydrate, and a halogen-based flame retardant.

The phosphorus-based flame retardant may be an inorganic phosphorus-based flame retardant or an organic phosphorus-based flame retardant.

Examples of the inorganic phosphorus-based flame retardant include red phosphorus; ammonium phosphates such as monoammonium phosphate, diammonium phosphate, triammonium phosphate, and ammonium polyphosphate; inorganic nitrogen-containing phosphorus compounds such as phosphoric acid amide; phosphoric acid; and phosphine oxide.

Examples of the organic phosphorus-based flame retardant include an aromatic phosphoric acid ester compound, a monosubstituted phosphonic acid diester compound, a disubstituted phosphinic acid ester compound, a metal salt of a disubstituted phosphinic acid, an organic nitrogen-containing phosphorus compound, and a cyclic organic phosphorus compound. Among these, an aromatic phosphate ester compound and a metal salt of a disubstituted phosphinic acid are preferable.

Examples of the metal hydrate include a hydrate of aluminum hydroxide and a hydrate of magnesium hydroxide.

Examples of the halogen-based flame retardant include a chlorine-based flame retardant and a bromine-based flame retardant.

### (Content of Flame Retardant (F))

When the resin composition of the present embodiment contains the flame retardant (F), the content of the flame retardant (F) is not particularly limited, and is preferably 1 to 50 parts by mass, more preferably 10 to 45 parts by mass, and still more preferably 30 to 40 parts by mass, with respect to 100 parts by mass of the total amount of the resin components in the resin composition of the present embodiment.

When the content of the flame retardant (F) is equal to or greater than the lower limit value, the flame retardancy tends to be more easily improved. On the other hand, when the content of the flame retardant (F) is equal to or less than the upper limit value, the moldability, adhesiveness with a conductor, and heat resistance tend to be more easily improved.

### <Other Components>

The resin composition of the present embodiment may further contain, if necessary, one or more selected from the group consisting of a resin material other than the above-mentioned components, an antioxidant, a thermal stabilizer, an antistatic agent, an ultraviolet absorber, a pigment, a colorant, a lubricant, and additives other than these. For each of these, one kind may be used alone, or two or more kinds may be used in combination. In addition, the use amount thereof is not particularly limited, and may be used in a range in which the effect of the present embodiment is not inhibited, if necessary.

### (Organic Solvent)

The resin composition of the present embodiment may contain an organic solvent from the viewpoint of facilitating handling and from the viewpoint of facilitating production of a prepreg to be described later.

The organic solvent may be used alone or may be used in combination of two or more thereof.

In the description herein, a resin composition containing an organic solvent may be referred to as a resin varnish.

Examples of the organic solvent include alcohol-based solvents such as ethanol, propanol, butanol, methyl cellosolve, butyl cellosolve, and propylene glycol monomethyl ether; ketone-based solvents such as acetone, methyl ethyl ketone, methyl isobutyl ketone, and cyclohexanone; ether-based solvents such as tetrahydrofuran; aromatic hydrocarbon-based solvents such as toluene, xylene, and mesitylene; nitrogen atom-containing solvents such as dimethylformamide, dimethylacetamide, and N-methylpyrrolidone; sulfur atom-containing solvents such as dimethyl sulfoxide; and ester-based solvents such as γ-butyrolactone.

Among these, from the viewpoint of solubility, an alcohol-based solvent, a ketone-based solvent, a nitrogen atom-containing solvent, and an aromatic hydrocarbon-based solvent are preferable, an aromatic hydrocarbon-based solvent is more preferable, and toluene is still more preferable.

### <Method for Producing Resin Composition>

The resin composition of the present embodiment can be produced by mixing the component (A), the component (B), other components used in combination as necessary by a known method. In this case, the respective components may be dissolved or dispersed while stirring. Conditions such as a mixing order, a temperature, and a time are not particularly limited, and may be arbitrarily set according to the type of raw material.

### <Relative Dielectric Constant (Dk) of Cured Product>

The relative dielectric constant (Dk) at 10 GHz of the cured product of the resin component of the present embodiment is not particularly limited, and is preferably 3.5 or less, more preferably 3.3 or less, and still more preferably 3.1 or less. The relative dielectric constant (Dk) is preferably as small as possible, and the lower limit value thereof is not particularly limited, and may be, for example, 2.4 or more, or 2.5 or more, in consideration of the balance with other physical properties.

The relative dielectric constant (Dk) is a value in accordance with a cavity resonator perturbation method, and more specifically, a value measured by a method described in Examples.

### <Dielectric Dissipation Factor (Df) of Cured Product>

The dielectric dissipation factor (Df) at 10 GHz of the cured product of the resin component of the present embodiment is not particularly limited, and is preferably 0.0040 or less, more preferably 0.0030 or less, and still more preferably 0.0020 or less. The dielectric dissipation factor (Df) is preferably as small as possible, and the lower limit value thereof is not particularly limited, but may be, for example, 0.0010 or more, or 0.0011 or more, in consideration of the balance with other physical properties.

The dielectric dissipation factor (Df) is a value in accordance with a cavity resonator perturbation method, and more specifically, a value measured by a method described in Examples.

### [Prepreg]

The prepreg of the present embodiment is a prepreg containing the resin composition of the present embodiment or a semi-cured product of the resin composition.

The prepreg of the present embodiment contains, for example, the resin composition of the present embodiment or a semi-cured product of the resin composition and a sheet-shaped fiber base material.

As the sheet-shaped fiber base material contained in the prepreg of the present embodiment, for example, known sheet-shaped fiber base materials used in various laminated boards for electrical insulating materials can be used.

Examples of the material of the sheet-shaped fiber base material include inorganic fibers such as E glass, D glass, S glass, and Q glass; organic fibers such as polyimide, polyester, and tetrafluoroethylene; and mixtures thereof. These sheet-shaped fiber base materials have a shape of, for example, a woven fabric, a nonwoven fabric, a roving, a chopped strand mat, or a surfacing mat.

The prepreg of the present embodiment can be produced by, for example, impregnating or coating the resin composition of the present embodiment into a sheet-shaped fiber base material and then heating and drying the impregnated or coated resin composition to make it B-stage.

The temperature and time of the heating and drying are not particularly limited, and from the viewpoint of productivity and appropriate B-staging of the resin composition of the present embodiment, for example, the temperature and time can be set to 50 to 200°C and 1 to 30 minutes.

The solid component concentration derived from the resin composition in the prepreg of the present embodiment is not particularly limited, and from the viewpoint of easily obtaining better moldability when a laminated board is formed, the solid content concentration is preferably 20 to 90% by mass, more preferably 25 to 80% by mass, and still more preferably 30 to 75% by mass.

### [Resin Film]

The resin film of the present embodiment is a resin film containing the resin composition of the present embodiment or a semi-cured product of the resin composition.

The resin film of the present embodiment can be produced, for example, by coating the resin composition of the present embodiment containing an organic solvent, that is, a resin varnish, on a support and then heating and drying the coating.

Examples of the support include a plastic film, a metal foil, and a release paper.

The temperature and time of the heating and drying are not particularly limited, and from the viewpoint of productivity and appropriate B-staging of the resin composition of the present embodiment, the temperature and time can be set to 50 to 200°C and 1 to 30 minutes.

The resin film of the present embodiment is preferably used for forming an insulating layer in the case of producing a printed wiring board.

### [Laminated Board]

The laminated board of the present embodiment is a laminated board having a cured product of the resin composition of the present embodiment of the present embodiment, and a metal foil.

A laminated board having a metal foil is sometimes referred to as a metal-clad laminated board.

The metal of the metal foil is not particularly limited, and examples thereof include copper, gold, silver, nickel, platinum, molybdenum, ruthenium, aluminum, tungsten, iron, titanium, chromium, and an alloy containing one or more kinds of these metal elements.

The laminated board of the present embodiment can be produced, for example, by disposing a metal foil on one surface or both surfaces of the prepreg of the present embodiment, and then subjecting the prepreg to heating and press molding.

Usually, the B-staged prepreg is cured by this heating and press molding to obtain the laminated board of the present embodiment.

When the heating and press molding is performed, only one prepreg may be used, or two or more prepregs may be laminated.

For the heating and press molding, for example, a multi-stage press, a multi-stage vacuum press, a continuous molding, or an autoclave molding machine can be used.

The conditions of the heating and press molding are not particularly limited, and the temperature may be 100 to 300°C, the time may be 10 to 300 minutes, and the pressure may be 1.5 to 5 MPa, for example.

### [Printed Wiring Board]

The printed wiring board of the present embodiment is a printed wiring board having a cured product of the resin composition of the present embodiment.

The printed wiring board of the present embodiment can be produced, for example, by performing conductor circuit formation by a known method on one or more kinds of materials selected from the group consisting of a cured product of the prepreg of the present embodiment, a cured product of the resin film of the present embodiment, and a laminated board. In addition, a multilayer printed wiring board can also be produced by further performing a multilayer adhesion process as necessary. The conductor circuit can be formed by, for example, appropriately performing a drilling process, a metal plating process, or etching of a metal foil.

### [Semiconductor Package]

The semiconductor package of the present embodiment includes the printed wiring board of the present embodiment and a semiconductor element.

The semiconductor package of the present embodiment can be produced, for example, by mounting a semiconductor element and a memory on the printed wiring board of the present embodiment by a known method.

### Examples

Hereinafter, the present embodiment will be specifically described with reference to Examples. However, the present embodiment is not limited to the following Examples.

In each example, the number-average molecular weight (Mn) and the weight-average molecular weight (Mw) were measured by the following procedure.

### (Measurement Method of Number-Average Molecular Weight (Mn) and Weight-Average Molecular Weight (Mw))

The number-average molecular weight (Mn) and the weight-average molecular weight (Mw) were converted from a calibration curve using standard polystyrene by gel permeation chromatography (GPC). The calibration curve was approximated by a cubic equation using standard polystyrene: TSK standard POLYSTYRENE (Type; A-2500, A-5000, F-1, F-2, F-4, F-10, F-20, F-40) [manufactured by Tosoh Corporation, trade name]. The measurement conditions of GPC are shown below.
Apparatus: high-speed GPC apparatus HLC-8320GPC
Detector: ultraviolet absorption detector UV-8320 [manufactured by Tosoh Corporation]
Column: guard column; TSK Guardcolumn SuperHZ-L + column; TSKgel SuperHZM-N + TSKgel SuperHZM-M + TSKgel SuperH-RC (all manufactured by Tosoh Corporation, trade names)
Column size: 4.6 × 20 mm (guard column), 4.6 × 150 mm (column), 6.0 × 150 mm (reference column)
Eluent: tetrahydrofuran
Sample concentration: 10 mg/5 mL
Injection volume: 25 µL
Flow rate: 1.00 mL/min
Measurement temperature: 40°C

### [Production of Modified Conjugated Diene Polymer]

### Production Example 1

100 parts by mass of 1,2-polybutadiene homopolymer (number-average molecular weight (Mn) = 1,200, vinyl group content = 85% or more), 4.4 parts by mass of 3,3'-dimethyl-5,5'-diethyl-4,4'-diphenylmethanebismaleimide, 0.1 parts by mass of α,α'-bis(t-butylperoxy)diisopropylbenzene, and toluene as an organic solvent were charged into a glass flask container having a volume of 2 L capable of being heated and cooled and equipped with a thermometer, a reflux cooling pipe, and a stirring device. Next, the mixture was stirred at 90°C to 100°C for 5 hours in a nitrogen atmosphere, thereby obtaining a solution of a modified conjugated diene polymer having a solid content concentration of 35% by mass.

### [Production of Resin Composition]

### [Examples 1 to 4, Comparative Examples 1 to 4]

The respective components described in Table 1 were blended together with toluene in accordance with the blending amounts described in Table 1, and the mixture was stirred and mixed at 25°C or while heating to 50 to 80°C to prepare a resin composition having a solid content concentration of about 50% by mass. In Table 1, the unit of the blending amount of each component is parts by mass, and in the case of a solution, the unit means parts by mass in terms of solid content.

### [Production of Resin Film and Resin Plate with Double-Sided Copper Foil]

The resin composition obtained in each example was applied to a PET film (manufactured by Teijin Limited, trade name: G2-38) having a thickness of 38 µm, and then dried by heating at 170°C for 5 minutes to prepare a resin film in a B-stage state. The resin film was peeled off from the PET film and pulverized to obtain a resin powder in a B-stage state, and the resin powder was introduced into a Teflon (registered trademark) sheet cut out to a size of 1 mm in thickness × 50 mm in length × 35 mm in width. Next, a low-profile copper foil (trade name: 3EC-VLP-18, manufactured by Mitsui Mining & Smelting Co., Ltd.) having a thickness of 18 µm was disposed on the upper and lower sides of the Teflon (registered trademark) sheet into which the resin powder had been introduced, thereby obtaining a laminate before heating and press molding. The low-profile copper foil was disposed with the M surface thereof facing the resin powder side. Subsequently, the laminate was subjected to heating and press molding under conditions of a temperature of 230°C and a pressure of 2.0 MPa and a time of 120 minutes, and the resin powder was molded into a resin plate and cured, thereby producing a resin plate with double-sided copper foil. The thickness of the resin plate portion of the obtained resin plate with double-sided copper foil was 1 mm.

### [Evaluation Method and Measurement Method]

Using the resin plate with double-sided copper foil obtained in each example, each measurement and evaluation were performed according to the following methods. The results are shown in Table 1.

### (Measurement Method of Relative Dielectric Constant and Dielectric Dissipation Factor)

The resin plate with double-sided copper foil obtained in each example was immersed in a 10% by mass solution of ammonium persulfate (manufactured by Mitsubishi Gas Chemical Company, Inc.) as a copper etching solution to remove the copper foil on both sides, thereby preparing a 2 mm × 50 mm test piece. Next, the relative dielectric constant (Dk) and dielectric dissipation factor (Df) of the test piece were measured in a 10 GHz band at an atmospheric temperature of 25°C in accordance with a cavity resonator perturbation method.

### (Measurement of Copper Foil Peel Strength)

The copper foil of the resin plate with double-sided copper foil obtained in each example was processed into a straight line shape having a width of 3 mm by etching and used as a test piece. The formed straight line-shaped copper foil was attached to a compact desktop tester (manufactured by Shimadzu Corporation, trade name: "EZ-TEST"), and the copper foil peel strength was measured by peeling in a 90° direction at room temperature (25°C) in accordance with JIS C 6481:1996. The pulling speed for peeling the copper foil was 50 mm/min.

### (Method for Evaluating Heat Resistance)

The copper foil on both sides of the resin plate with double-sided copper foil obtained in each example was removed by etching to prepare a 40 mm × 40 mm test piece. Next, the test piece was treated under conditions of 121°C and 0.11 MPa using a pressure cooker (manufactured by HIRAYAMA Manufacturing Corporation, trade name: HA-300M). The treated test piece was immersed in a molten solder bath at 288°C for 20 seconds, and then the appearance of the test piece was visually observed, and the heat resistance was evaluated according to the following criteria.
A: No swelling was observed.
C: Swelling was observed.

### (Measurement Method of Melt Viscosity)

The resin film obtained in each example was peeled off from the PET film, and then pulverized to obtain a resin powder in a B-stage state. About 0.6 g of the resin powder was weighed and formed into a disc-shaped tablet having a diameter of 20 mm by a tableting machine. Subsequently, using this tablet as a measurement sample, the viscosity was measured using a rheometer (trade name: ARES-2K STD-FCO-STD, manufactured by Rheometric Company) under conditions of a temperature increase rate of 3°C/min, a load of 0.2 N, and a measurement temperature range of 50°C to 200°C, and the lowest melt viscosity was taken as the melt viscosity.

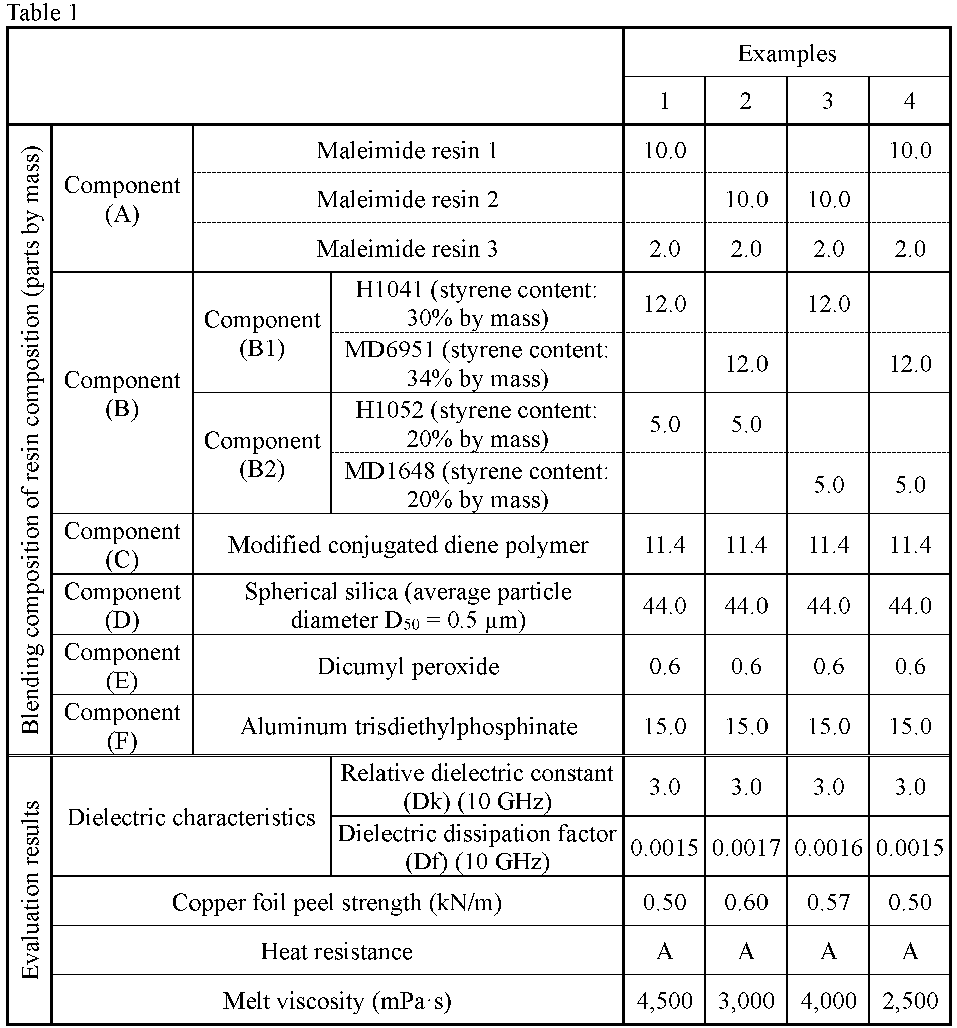

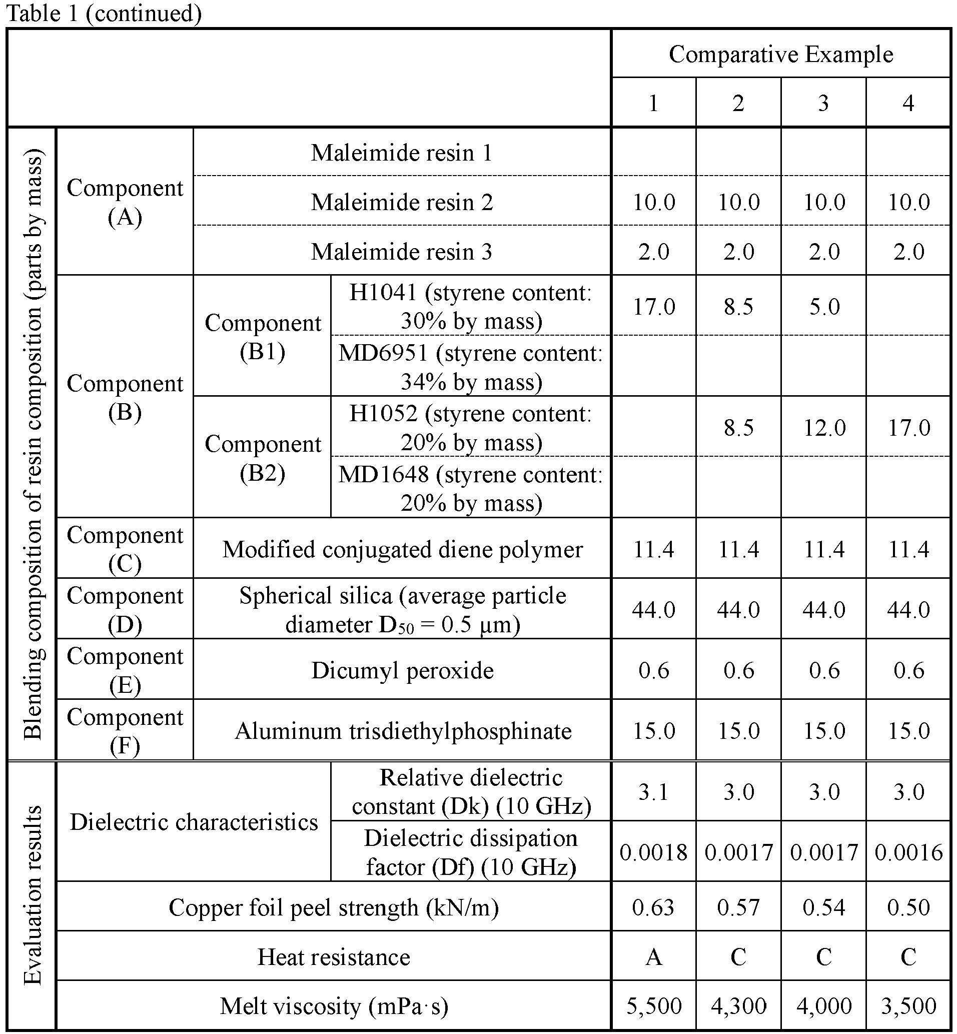

The details of each material described in Table 1 are as follows.
[Component (A)]
   ·Maleimide resin 1: aromatic bismaleimide resin containing an indane ring
   ·Maleimide resin 2: biphenyl aralkyl type maleimide (manufactured by Nippon Kayaku Co., Ltd., trade name "MIR-3000")
   ·Maleimide resin 3: 3,3'-dimethyl-5,5'-diethyl-4,4'-diphenylmethane bismaleimide
[Component (B)]
<Component (B1)>
   ·H1041: styrene-ethylene-butylene-styrene block copolymer (SEBS), manufactured by Asahi Kasei Corporation, trade name "Tuftec H1041", styrene content: 30% by mass, number-average molecular weight (Mn): 101,300, weight-average molecular weight (Mw): 115,200
   ·MD6951: styrene-ethylene-butylene-styrene block copolymer (SEBS), manufactured by Kraton Polymer Japan, "KRATON (registered trademark) MD6951", styrene content: 34% by mass, number-average molecular weight (Mn): 57,800, weight-average molecular weight (Mw): 77,700
<Component (B2)>
   ·H1052: styrene-ethylene-butylene-styrene block copolymer (SEBS), manufactured by Asahi Kasei Corporation, trade name "Tuftec H1052", styrene content: 20% by mass, number-average molecular weight (Mn): 88,700, weight-average molecular weight (Mw): 105,500
   ·MD1648: styrene-ethylene-butylene-styrene block copolymer (SEBS), manufactured by Kraton Polymer Japan, "KRATON (registered trademark) MD1648", styrene content: 20% by mass, number-average molecular weight (Mn): 26,400, weight-average molecular weight (Mw): 146,900
[Component (C)]
   ·Modified conjugated diene polymer: modified conjugated diene polymer obtained in Production Example 1

From the results shown in Table 1, it can be seen that the resin compositions of Examples 1 to 4 of the present embodiment have both a low dielectric dissipation factor and heat resistance at a high level. On the other hand, the resin compositions of Comparative Examples 1 to 4 were inferior in either dielectric characteristics or heat resistance.

### Industrial Applicability

Since the cured product produced from the resin composition of the present embodiment has a low dielectric dissipation factor and excellent heat resistance, a prepreg, a laminated board, a printed wiring board, and a semiconductor package obtained by using the resin composition are particularly suitable for electronic components handling high-frequency signals.

## Claims

1. A resin composition comprising (A) a thermosetting resin and (B) a copolymer resin containing a structural unit derived from an aromatic vinyl compound and a structural unit derived from an unsaturated aliphatic hydrocarbon,
wherein the component (B) contains
a component (B 1) having a content of a structural unit derived from an aromatic vinyl compound of 25 to 60% by mass, and
a component (B2) having a content of a structural unit derived from an aromatic vinyl compound of less than that of the component (B1) on a mass basis, and
the content of the component (B1) in the resin composition is greater than the content of the component (B2) in the resin composition on a mass basis.

2. The resin composition according to claim 1, wherein the structural unit derived from an aromatic vinyl compound contained in the component (B) is a structural unit derived from styrene.

3. The resin composition according to claim 1 or 2, wherein the structural unit derived from an unsaturated aliphatic hydrocarbon is a structural unit obtained by hydrogenating a structural unit formed by addition polymerization of a conjugated diene compound.

4. The resin composition according to claim 1 or 2, wherein a ratio of the content of the component (B1) to the content of the component (B2) [(B1)/(B2)] is 1.1 to 10 in terms of a mass ratio.

5. The resin composition according to claim 1 or 2, wherein the thermosetting resin (A) is one or more selected from the group consisting of a maleimide resin having one or more N-substituted maleimide groups and a derivative thereof.

6. The resin composition according to claim 1 or 2, further comprising (C) one or more selected from the group consisting of a conjugated diene polymer and a modified conjugated diene polymer.

7. A prepreg comprising the resin composition according to claim 1 or 2 or a semi-cured product of the resin composition.

8. A laminated board comprising a cured product of the resin composition according to claim 1 or 2, and a metal foil.

9. A resin film comprising the resin composition according to claim 1 or 2 or a semi-cured product of the resin composition.

10. A printed wiring board comprising a cured product of the resin composition according to claim 1 or 2.

11. A semiconductor package comprising the printed wiring board according to claim 10, and a semiconductor element.
